# EUROPÄISCHE PATENTSCHRIFT

(11) **EP 0 357 909 B1**
(45) Veröffentlichungstag und Bekanntmachung des Hinweises auf die Patenterteilung: **17.11.1994**
(21) Anmeldenummer: 89112812.6
(22) Anmeldetag: 13.07.1989
(51) Int. Cl.: G08C 23/00

(54) **Fernbedienbares elektrisches Gerät**
Remote control electrical device
Appareil électrique de commande à distance

(30) Priorität: 20.08.1988 DE 3828334
(43) Veröffentlichungstag der Anmeldung: 14.03.1990
(73) Patentinhaber: Nokia (Deutschland) GmbH, 75175 Pforzheim (DE)
(72) Erfinder: Reime, Gerd, D-7131 Wurmberg (DE)

(56) Entgegenhaltungen:
- EP-A- 0 209 411
- WO-A-88/04060
- US-A- 4 150 285
- US-A- 4 565 999
- US-A- 4 745 402

## Beschreibung

Die Erfindung betrifft ein fernbedienbares elektrisches Gerät nach dem Oberbegriff des Anspruchs 1.

Zur Einstellung und Steuerung bestimmter Betriebszustände derartiger fernbedienbarer elektrischer Geräte ist ein Fernbedienungsgeber vorgesehen, mit dem ein Benutzer des fernbedienbaren Gerätes die Bedienungsbefehle einstellt. Das fernbedienbare Gerät enthält einen Fernbedienungsempfänger, der die vom Fernbedienungsgeber ausgestrahlten Fernsteuersignale empfängt und in die entsprechenden Steuersignale zur Einstellung und Steuerung des gewünschten Betriebszustandes umwandelt.

Aus der DE-Zeitschrift "Funkschau" 1978, Heft 20, Seiten 963 bis 966, ist ein Fernsteuersystem bekannt, mit dem ein fernbedienbares elektrisches Gerät über einen schnurlos von dem fernbedienbaren Gerät abgesetzten Fernbedienungsgeber bedient werden kann. Aus einem Tastenfeld des Fernbedienungsgebers betätigte Tasten rufen aus einem Signalspeicher zugehörige Steuersignale ab, die über eine in dem Fernbedienungsgeber gebildete Trägerwelle an den Fernbedienungsempfänger des fernzubedienenden Gerätes übertragen werden. Der Fernbedienungsempfänger bildet daraus die entsprechenden Schalt- und Steuersignale zur Einstellung und Steuerung des fernzubedienenden Gerätes.

Je mehr Einstell- und Ablaufzustände über den Fernbedienungsgeber an dem fernbedienbaren elektrischen Gerät eingestellt werden können, um so unübersichtlicher und unbedienbarer wird der Fernbedienungsgeber für den ungeübten und gelegentlichen Benutzer eines derartigen Gerätes. Deshalb wird nach der DE-PS 32 28 354 versucht, durch eine sichtbare Benutzerführung auf einem Display oder Bildschirm des Fernbedienungsempfängers oder des fernzubedienenden Gerätes die Tastenvielfalt auf dem Fernbedienungsgeber wesentlich zu verringern und gleichzeitig dem Benutzer zusätzlich eine ausschnittweise Bedienungsanleitung zu vermitteln. Trotz der unbestreitbaren Bedienungserleichterung ist der ungeübte Benutzer der Fernbedienung eines derartigen Gerätes immer noch gezwungen, den Fernbedienungsgeber mit zwei Händen zu handhaben und beim Bedienen des Fernbedienungsgebers sowohl die Einstellungshandlungen auf dem Fernbedienungsgeber, als auch das auf dem Display des fernzubedienenden Gerätes dargestellte Bedienungsmenü zu beobachten.

Bei der Benutzerführung wird im allgemeinen ein Menü auf einem Bildschirm dargestellt und einzelne Bestandteile des Menüs vom Benutzer mit einem im Menü auf dem Bildschirm verschiebbaren Cursor ausgewählt. Aus der US-PS 4.745.402 ist es bekannt, den Cursor auf dem Bildschirm mittels eines in der Hand geführten Fernbedienungsgebers zu verschieben. Dazu enthält der aus der Druckschrift bekannte Fernbedienungsgeber mehrere IR-Sendeelemente, deren Abstrahlungscharakteristik stark gebündelt ist und die in ihren Abstrahlungsrichtungen leicht voneinander divergierend angeordnet sind. Die einzelnen Sendeelemente werden in einem bestimmten Phasen- und Zeitmuster aktiviert und entsprechend synchron vom Fernbedienungsempfänger des aus der Druckschrift bekannten fernbedienbaren elektrischen Gerätes empfangen. In einem Richtungsdetektor des Gerätes werden daraus Winkelpositionsdaten erstellt, die in einem Interface an die Dateneingabe eines Computers zur Steuerung des Cursors angepaßt werden.

Bei den bekannten fernbedienbaren elektrischen Geräten, bei denen die Fernbedienung durch Winkelablagen von einer bestimmten Zeigerrichtung des Fernbedienungsgebers gesteuert wird, werden die Strahlungsfelder zum Ermitteln der Winkelablage im Fernbedienungsgeber erzeugt. Die dafür notwendige Energie entnimmt der Fernbedienungsgeber seiner Stromversorgung, insbesondere den eingelegten Batterien.

Der Erfindung liegt deshalb die Aufgabe zugrunde, bei fernbedienbaren elektrischen Geräten mit einer großen Zahl einstellbarer Betriebszustände und Betriebsabläufen, bei denen zur Vereinfachung des Vorganges der Fernbedienung wenigstens wesentlicher Betriebszustände oder Betriebsabläufe durch eine Ablage der Zeigerichtung des Fernbedienungsgebers von einer Nennzeigerichtung eingestellt werden, die hierzu notwendigen und energieerfordernden Strahlungsfelder nicht im Fernbedienungsgeber zu erzeugen.

Diese Aufgabe wird für die eingangs angegebenen fernbedienbaren Geräte erfindungsgemäß durch die Merkmale des kennzeichnenden Teils sowohl des Anspruches 1 als auch des Anspruches 3 gelöst.

Der Unteranspruch 2 kennzeichnet eine vorteilhafte Ausgestaltungen der Erfindung.

Nachfolgend wird die Erfindung anhand vorteilhafter Ausführungsbeispiele näher erläutert. In den zugehörigen Zeichnungen zeigen
- Fig. 1: eine schematische Darstellung eines fernbedienbaren elektrischen Gerätes mit einem drahtlos davon abgesetzten, in einer Hand gehaltenen Fernbedienungsgeber,
- Figur 2: ein Blockschaltbild eines Fernbedienungsgebers und eines Fernbedienungsempfängers des in Fig. 1 dargestellten fernbedienbaren elektrischen Gerätes,
- Figur 3: ein Blockschaltbild eines Ausführungsbeispiels einer Fernbedienungseinrichtung eines fernbedienbaren elektrischen Gerätes,
- Figur 4: ein Blockschaltbild einer Fernbedienungseinrichtung eines fernbedienbaren elektrischen Gerätes innerhalb einer Gerätekombination,
- Figur 5: eine perspektivische Darstellung eines Fernbedienungsgebers in einer Sicht im wesentlichen auf die Empfangs- und Abstrahlungsseite.

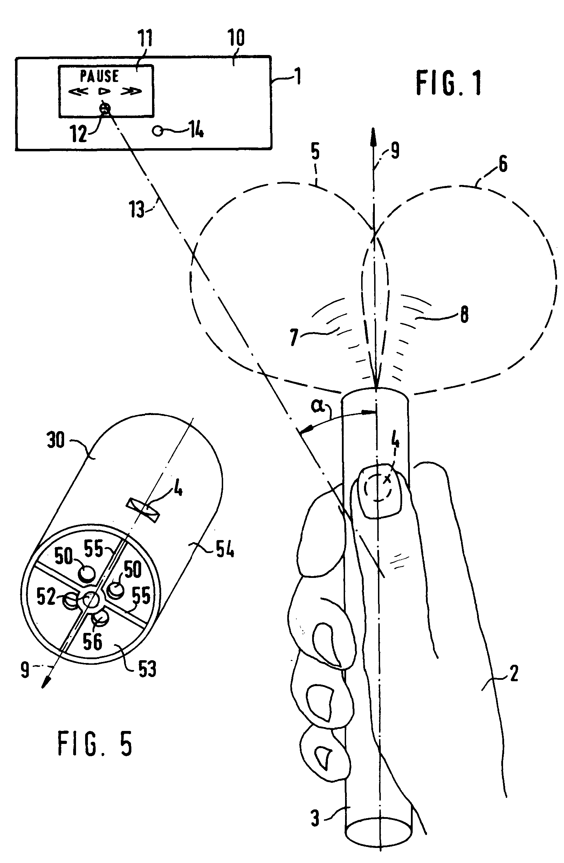

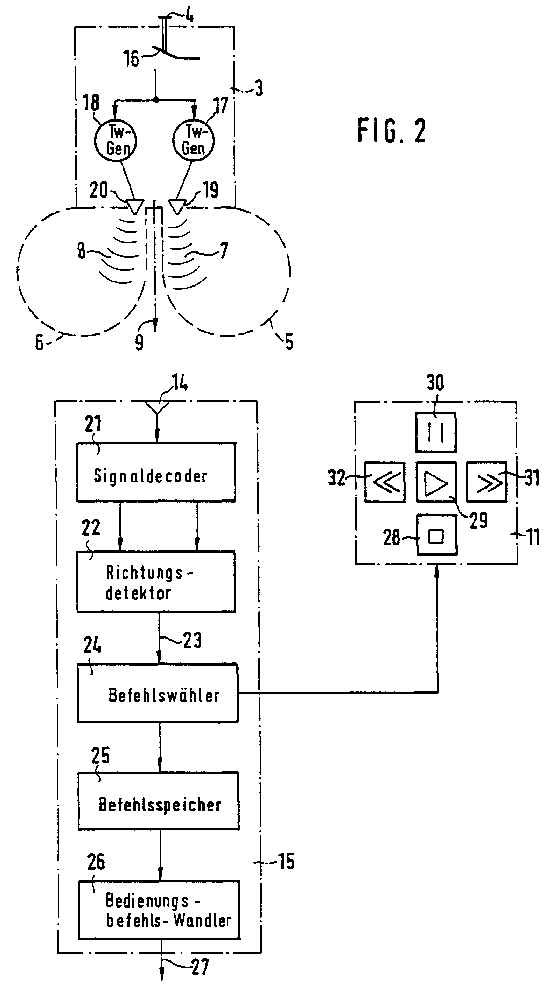

Anhand eines in den Figuren 1 und 2 dargestellten Ausführungsbeispieles wird die Ferneinstellung eines fernbedienbaren elektrischen Gerätes näher erläutert, das von einem in der Hand 2 eines Benutzers gehaltenen Fernbedienungsgeber 3 ferngesteuert wird. Der Fernbedienungsgeber 3 enthält eine Drucktaste 4, die mit dem Daumen der Hand 2 betätigt wird und die dazu dient, den Sendebetriebszustand des Fernbedienungsgebers einzuschalten und die Bedienungslage des Fernbedienungsgebers zur Hand des Benutzers einzustellen. Im dargestellten Ausführungsbeispiel sendet der Fernbedienungsgeber 3 im Sendebetriebszustand vier Trägerwellen aus,
die in bestimmter Weise von einander unterscheidbar gekennzeichnet sind, beispielsweise durch unterschiedliche Trägerwellenfrequenzen und/oder durch unterschiedliche auf die Trägerwellen aufmodulierte Kennungssignale. Von den vier Trägerwellen ist in Fig. 1 die räumliche Intensität des Abstrahlungsfeldes 5 und 6 zweier dieser Trägerwellen 7 und 8 schematisch dargestellt. Das Abstrahlungsfeld dieser Trägerwellen ist im wesentlichen durch in der Fig. 1 nicht gesondert dargestellte Ebenen begrenzt, die aufeinander senkrecht stehen und in denen die Zeigerrichtung 9 des Fernbedienungsgebers 3 verläuft.

Das in Fig. 1 dargestellte fernbedienbare elektrische Gerät 1 enthält auf seiner Frontseite 10 ein Display 11, das den Betriebszustand des Gerätes 1 anzeigt. Dieses Display 11 ist im dargestellten Ausführungsbeispiel ein Markierumgselement 12, auf das normalerweise der Fernbedienungsgeber 3 zur Fernbedienung des Gerätes 1 gerichtet wird, so daß die Zeigerrichtung 9 des Fernbedienungsgebers 3 in eine Linie 13 fällt, die vom augenblicklichen Ort des in der Hand gehaltenen Fernbedienungsgebers 3 zum Markierumgselement 12 verläuft und hier mit Markierungsrichtung 13 bezeichnet wird. Zur Fernbedienung des elektrischen Gerätes 1, d. h. zur Einstellung eines bestimmten Betriebszustandes oder Betriebsablaufes des elektrischen Gerätes 1, wird der Fernbedienungsgeber 3 in einer bestimmten Richtung (im dargestellten Ausführungsbeispiel nach rechts) um einen Ablagewinkel Alpha aus der Markierungsrichtung 13 verschwenkt. Die Winkelablage Alpha muß wenigstens so groß sein, daß das Abstrahlungsfeld (6) wenigstens einer Trägerwelle (8) ein zum Empfang dieser Trägerwellen vorgesehenes Empfangselement 14 des elektrischen Gerätes 1 nicht mehr wirksam erreicht. Dadurch wird im dem elektrischen Gerät 1 eine Richtungsablage des Fernbedienungsgebers 3 detektiert, solange der Fernbedienungsgeber im Sendebetriebszustand ist.

In Fig. 2 ist ein Blockschaltbild des in Fig. 1 dargestellten Fernbedienungsgebers 3 und eines in dem fernbedienbaren elektrischen Gerät 1 enthaltenen Fernbedienungsempfängers 15 dargestellt. Die Drucktaste 4 ist ein Bestandteil eines elektrischen Schalters 16, der im betätigten Zustand Trägerwellengeneratoren 17, 18 wirksam schaltet. Diese Trägerwellengeneratoren erzeugen die besonders gekennzeichneten Trägerwellen 7, 8, die der Fernbedienungsgeber 3 im Sendebetriebszustand über Sendeelemente 19, 20 des Fernbedienungsgebers abstrahlt. Die Sendeelemente 19, 20 und ihre Anbringung im Gehäuse des Fernbedienungsgebers 3 sich so ausgestaltet, daß sie die weiter oben angegebenen räumlichen Abstrahlungsfelder 5, 6 erzeugen.

In einem Signaldecoder 21 des Fernbedienungsempfängers 15 des elektrischen Gerätes 1 wird die Kennung der über das Empfangselement 14 des Fernbedienungsempfängers 15 empfangenen Trägerwellen geprüft und aus der Empfangsfeldstärke der zugelassenen Trägerwellen 7, 8 den Ablagewinkel Alpha des Fernbedienungsgebers 3 kennzeichnende Signale erzeugt, aus denen ein Richtungsdetektor 22 ein von der Winkelablage Alpha abhängiges Steuersignal 23 für einen Befehlswähler 24 bildet. Dieses Steuersignal 23 erzeugt in dem Befehlswähler 24 einen Programmablauf, der außerdem noch vom Betriebszustand des elektrischen Gerätes 1 abhängig ist, in dem sich das elektrische Gerät 1 vor dem Auftreten des Steuersignals 23 befand, und der die für den gewünschten Betriebszustand oder Betriebsablauf erforderlichen Bedienungsbefehle aus einem Befehlsspeicher 25 abruft. Ein Bedienungsbefehlswandler 26 des Fernbedienungsempfängers 15 wandelt die abgerufenen Bedienungsbefehle, in dem elektrischen Gerät 1 entsprechende Funktionssteuersignale 27 zur Einstellung des mit dem Fernbedienungsgeber 3 ausgewählten Betriebszustandes oder Betriebsablaufes des elektrischen Gerätes um. Der Befehlswähler 24 steuert im dargestellten Ausführungsbeispiel außerdem ein Display 11 des fernbedienbaren elektrischen Gerätes 1. Dieses Display 11, das gleichzeitig das visuell sichtbare Markierungselement 12 für den Fernbedienungsgeber 3 des elektrischen Gerätes 1 darstellt, dient zur Anzeige des Betriebszustandes des elektrischen Gerätes. Im darge- stellten Ausführungsbeispiel ist das fernbedienbare elek- trische Gerät 1 ein Videorecorder. Das untere Bild 28 des Displays 11 kennzeichnet den stand-by-Betriebszustand, das mittlere Bild 29 den normalen Laufzustand (PLAY) und das obere Bild 30 den Standbild- oder Pausenzustand des Videorecorders. Die Bilder 31 und 32 links und rechts des mittleren Bildes 29 geben die Laufrichtung und Laufgeschwindigkeit des Videosignalträgers in den verschiedenen eingestellten Betriebszuständen des Videorecorders an. Schwenkt der Benutzer beim dargestellten Ausführungsbeispiel den Fernbedienungsgeber 3 nach rechts und schaltet danach den Fernbedienungsgeber in den Sendebetriebszustand, dann schaltet er den schnellen Vorwärtslauf des Videosignalträgers ein, wenn der Videorecorder sich im stand-by-Betriebszustand befand. Zum Stoppen dieses Schnellaufes betätigt der Benutzer den Fernbedienungsgeber in einer nach mitte unten gerichteten Stellung des Fernbedienungsgebers. Bei einer Handhabungsstellung des Fernbedienungegebers nach mitte oben wird der Videorecorder in den normalen Wiedergabezustand PLAY geschaltet und nach einer weiteren Betätigung der Drucktaste 4 in dieser Stellung in den Standbildbetriebszustand geschaltet. Schwenkt danach der Benutzer den Fernbedienungsgeber erneut nach oben, so schaltet er bei jeder Betätigung der Drucktaste 4 des Fernbedienungsgebers 3 die Videobildwiedergabe um ein Vollbild vorwärts. Schwenkt er dagegen den eingeschalteten Fernbedienungsgeber nach rechts, so schaltet er damit den Videorecorder in den Betriebszustand einer verlangsamten Wiedergabegeschwindigkeit der Bildwiedergabe.

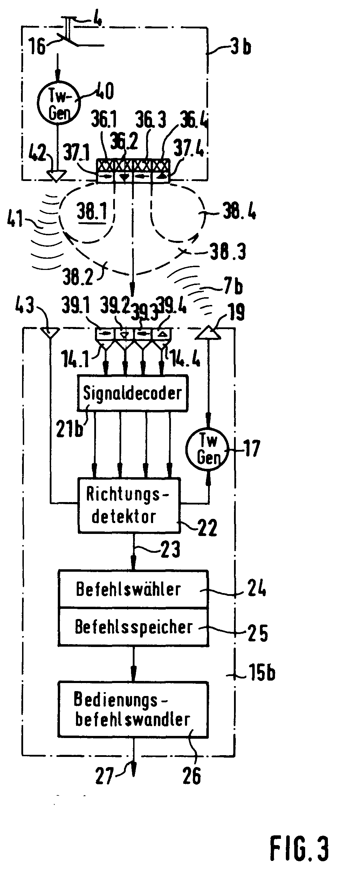

Bei einer in Fig. 3 dargestellten Fernbedienungseinrichtung ist der Trägerwellengenerator 17 für die Trägerwelle 7b, die zur Bildung von der Winkelablage Alpha des Fernbedienungsgebers 3b dieser Einrichtung entsprechenden Signalen vorgesehen ist, im Fernbedienungsempfänger 15b angeordnet. Ein Sendelement 19 des Fernbedienungsempfängers strahlt diese Trägerwelle 7b ungebrenzt aus. Im dargestellten Ausführungsbeispiel ist die Trägerwelle 7b eine polarisierbare Infrarotlichtwelle einer bestimmten Wellenlänge und gegebenenfalls mit einer zusätzlichen Kennung versehen. Der zugehörige Fernbedienungsgeber 3b enthält vier Reflexionselemente 36,1 bis 36,4, denen je ein Polarisationsfilter 37,1 bis 37,4 vorgesetzt ist. Jedes dieser Polarisationsfilter enthält eine andere, in der Zeichnung durch einen Pfeil gekennzeichnete Polarisation, so daß vier unterschiedlich polarisierte Lichtquellen am Fernbedienungsgeber 3b entstehen. Die Polarisationsfilter und ihre Anbringung im Gehäuse des Fernbedienungsgebers 3b sind so beschaffen, daß deren räumliche Empfangs- und Rückstrahlungsfelder 38,1 bis 38,4 gegeneinander im wesentlichen durch zwei senkrecht zueinander stehende Ebenen begrenzt sind, in denen die Zeigerrichtung 9 des Fernbedienungsgebers 3b verläuft.

Zum Empfang der reflektierten Strahlungen enthält das fernbedienbare elektrische Gerät 1 vier Empfangselemente 14,1 bis 14,4, denen unterschiedlich polarisierte Polarisationsfilter 39,1 bis 39,4 vorgesetzt sind. Die Polarisation der reflektierten Lichtwellen ist eine Kennung dieser Lichtwellen. Die Empfangselemente 14,1 bis 14,4 sind an einen Signaldetektor 21b des Fernbedienungsempfängers 15b des elektrischen Gerätes 1 angeschlossen, der die Empfangsfeldstärken der empfangenen reflektierten Lichtwellen mißt und daraus die Ablage der Zeigerrichtung des Fernbedienungsgebers 3b kennzeichnende Signale für den Richtungsdetektor 22 des Fernbedienungsempfängers 15b bildet.

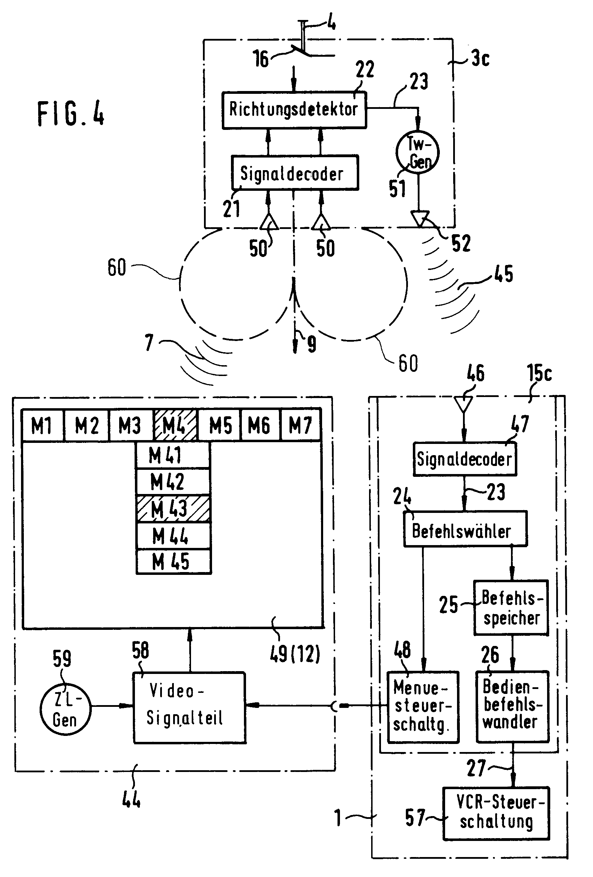

Der Fernbedienungsgeber 3b des in Fig. 4 dargestellten Ausführungsbeispieles enthält außerdem einen Hilfsträgerwellengenerator 40, der beim Betätigen der Drucktaste 4 des Fernbedienungsgebers 3b eine Hilfsträgerwelle 41 erzeugt. Diese Hilfsträgerwelle 41, die von einem Sendeelement 42 des Fernbedienungsgebers 3b an ein Empfangselement 43 des Fernbedienungsempfängers 15b übertragen wird, schaltet über den Richtungsdetektor 22 den Fernbedienungsempfänger 15b des elektrischen Gerätes 1 und damit die Fernbedienungseinrichtung des fernbedienbaren elektrischen Gerätes ein.

In Fig. 4 ist ein Ausführungsbeispiel einer Fernbedienungseinrichtung zur Fernbedienung eines Videorecorders als elektrisches Gerät 1 dargestellt, an das ein Fernsehgerät 44 angeschlossen ist. Der Videorecorder enthält einen Fernbedienungsempfänger 15c mit dem er die von einem Fernbedienungsgeber 3c auf einer Trägerwelle 45 abgestrahlten Fernsteuersignale empfängt und die Steuersignale 27 für eine Steuerschaltung 57 des Videorecorders umsetzt. Dazu enthält der Fernbedienungsempfänger 15c ein Emfpangselement 46, das die empfangene Trägerwelle 45 in ein elektrisches Signal umwandelt und einem nachgeschalteten Signaldecoder 47 zuleitet. Dieser decodiert daraus die in einem Richtungsdetektor 22 des Fernbedienungsgebers 3c gebildete, von der Winkelablage Alpha des Fernbedienungsgebers 3c abhängigen Steuersignale 23 zur entsprechenden Steuerung des Befehlswählers 24 des Fernbedienungsempfängers 15c.

An den Befehlswähler 24 ist außerdem eine Menüsteuerschaltung 48 des Fernbedienungsempfängers angeschlossen, die über ein Videosignalteil 58 den Programmablaufzustand des Befehlswählers 24 auf dem Bildschirm 49 des an den Videorecorder angeschlossenen Fernsehgerätes 44 zur Anzeige bringt. Der Bildschirm 49 des Fernsehgerätes 44 stellt während eines Bedienungsvorganges der Fernbedienungseinrichtung sowohl das Display (11) für den Fernbedienungsempfänger 15c sowie das visuell sichtbare Markierungselement (12) für den Benutzer der Geräte als auch das Sendeelement (19) für die Abstrahlung einer Trägerwelle 7 dar, mit deren Hilfe die Winkelablage Alpha der Zeigerrichtung 9 des Fernbedienungsgebers 3c von der Richtung 13 auf das visuell sichtbare Markierungselement (12) ermittelt wird.

Die vom Bildschirm 49 abgestrahlte Trägerwelle 7 ist die Lichtinformation der vom Bildschirm wiedergegebenen Videobilder. Diese Lichtinformation enthält als Kennung die Zeilensynchronimpulse mit der Zeilenfrequenz eines Zeilengenerators 59 des Fernsehempfängers 44 als Folgefrequenz. Diese Lichtinformation wird mittels der richtungsabhängigen Empfangselemente 50 des Fernbedienungsgebers 3c empfangen und als elektrische Signale einem Signaldecoder 21 zugeführt, der die Intensität dieser Lichtinformationen mißt und dieser Intensität entsprechende Signale an den Richtungsdetektor 22 des Fernbedienungsgebers 3c ausgibt. Die daraus vom Richtungsdetektor 22 erzeugten, die Winkelablage Alpha des Fernbedienungsgebers kennzeichnenden Steuersignale 23 werden der in einem Trägerwellengenerator 51 erzeugten zweiten Trägerwelle 45 aufmoduliert und über ein Sendeelement 52 des Fernbedie- nungsgebers 3c an den Fernbedienungsempfänger 15c übertragen.

In Fig. 5 ist ein Fernbedienungsgeber 3c, der Bestandteil des in Fig. 5 dargestellten Ausführungsbeispiels ist, in einer Sicht im wesentlichen auf seine Sende- und Empfangsseite perspektivisch dargestellt. Diese Seite ist die Stirnseite 53 des Gehäuses 54 des Fernbedienungsgebers in dessen Zeigerrichtung 9. Die Stirnseite 53 enthält vier Abschattungswände 55, die zusammen mit je einer Vertiefung 56, in denen die Empfangselemente 50 angeordnet sind, für jedes Empfangselement ein räumliches Empfangsfeld 57 bilden, das nicht wesentlich über fiktive Ebenen greift, die in den Abschattungswänden liegen. Im Kreuzungsbereich des Abschattungswände 55 ist das Sendelement 52 zur Abstrahlung der die Fernsteuersignale enthaltenden Trägerwelle 45 angeordnet. Auf der zylinderförmigen Wand des Gehäuses 54 ist die Drucktaste 4 angeordnet, die zum Einschalten der Fernbedienungseinrichtung vorgesehen ist und die die Bedienungslage des Fernbedienungsgebers 3c in der Hand 2 des Benutzers festlegt.

In dem in Fig. 5 dargestellten Ausführungsbeispiel wird der Videorecorder über eine im Befehlswähler 24 angeordnete Menüprogramme in seinen Betriebszuständen und Betriebsabläufen gesteuert. Für jede Bedienungsebene ist ein Menü vorgesehen. Zur Wahl eines der Menüs M1 bis M7 wird der Fernbedienungsgeber 3c mit betätigter Drucktaste 4 solange nach rechts oder links zur Seite verschwenkt, bis auf dem Bildschirm 49 das gewünschte Menü, z. B. das Menü M4, besonders beleuchtet ist. Danach wird durch Abwärts- oder Aufwärtshalten des Fernbedienungsgebers 3c die gewünschte Bedienungseinstellung M43 aus den möglichen Bedienungseinstellungen M41 bis M45 der eingestellten Bedienungsebene M4 ausgesucht. Die besonders beleuchteten Menüanzeigen (M4 und M43) auf dem Bildschirm 49 geben die Einstellung des Befehlswählers 24 wieder, der im dargestellten Ausführungsbeipsiel durch ein Betätigen der Drucktaste 4 bei auf die Mitte des Bildschirmes 49 gerichtetem Fernbedienungsgeber 3c den Befehlswähler 24 des Fernbedienungsempfängers 15c wirksam schaltet, so daß er die für den ausgewählten Betriebszustand oder Betriebablauf des Videorecorders erforderlichen Bedienungsbefehl aus dem Befehlsspeicher 25 abruft. Diese Bedienungsbefehle werden im Bedienungsbefehlswandler 26 in die für die Steuerschaltung 57 des Videorecorders erforderlichen Funktionssteuersignale 27 umgewandelt. Die Menüanzeige auf dem Bildschirm 49 erlischt mit Beginn des Abrufes der Bedienungsbefehle aus dem Befehlsspeicher.

## Patentansprüche

1. Fernbedienbares elektrisches Gerät
- mit einem Fernbedienungsempfänger und einem vom Fernbedienungsempfänger drahtlos abgesetzten handbetätigten Fernbedienungsgeber mit mindestens einem Sendeelement (52), zwischen denen Sendeelemente Fernsteuersignale an Empfangselemente abstrahlen zum Kennzeichnen der Winkelablage (Alpha) der Zeigerrichtung (9) des in Betrieb befindlichen Fernbedienungsgebers (3) von einer Markierungsrichtung (13), die den Fernbedienungsgeber und ein visuelles Markierungselement (12) am Fernbedienungsempfänger (15) verbindet,
- und mit einem Richtungsdetektor (22), der an einen Befehlswähler (24) Steuersignale (23), die der Winkelablage des Fernbedienungsgebers entsprechen, zum Einstellen bestimmter Betriebszustände des fernbedienbaren Gerätes überträgt,
**dadurch gekennzeichnet,**
- daß der Fernbedienungsempfänger (15c) einen Trägerwellengenerator (59) enthält, der eine Trägerwelle (7) mit einer bestimmten Kennung erzeugt, und ein Senderelement (19) zur Abstrahlung dieser Trägerwelle enthält,
- daß im Fernbedienungsgeber (3c) angeordnet sind:
-- ein Drucktaster (4) zum Einschalten eines Sendebetriebes des Fernbedienungsgebers (3c)
-- mehrere Empfangselemente (50) zum Empfang der Trägerwelle (7), deren räumliches Empfangsfeld durch Ebenen begrenzt ist, in denen die Zeigerrichtung (9) des Fernbedienungsgebers verläuft
-- der Richtungsdetektor (22), der auf die Kennung der Trägerwelle abgestimmt ist, und
-- ein zweiter Trägerwellengenerator (51), der mit dem Sendeelement (52) verbunden ist
- und daß der Richtungsdetektor (22) Steuersignale (23) erzeugt, die der im zweiten Trägerwellengenerator (51) erzeugten Trägerwelle (45) als Fernsteuersignale aufmoduliert sind.

2. Fernbedienbares elektrisches Gerät nach Anspruch 1 dadurch gekennzeichnet, daß der Bildschirm (49) des Fernbedienungsempfängers (15c) zugleich Sendeelement zur Abstrahlung der Trägerwelle (7) und Markierungselement ist und daß der Trägerwellengenerator (59), der eine Trägerwelle (7) mit einer bestimmten Kennung erzeugt, der Zeilengenerator des Fernbedienungsempfängers (15c) ist.

3. Fernbedienbares elektrisches Gerät
- mit einem Fernbedienungsempfänger und einem vom Fernbedienungsempfänger drahtlos abgesetzten handbetätigten Fernbedienungsgeber mit mindestens einem Sendeelement (42), zwischen denen Sendeelemente Fernsteuersignale an Empfangselemente abstrahlen zum Kennzeichnen der Winkelablage (Alpha) der Zeigerichtung (9) des in Betrieb befindlichen Fernbedienungsgebers (3) von einer Markierungsrichtung (13), die den Fernbedienungsgeber und ein visuelles Markierungselement (12) am Fernbedienungsempfänger (15) verbindet,
- und mit einem Richtungsdetektor (22), der an einen Befehlswähler (24) Steuersignale (23), die der Winkelablage des Fernbedienungsgebers entsprechen, zum Einstellen bestimmter Betriebszustände des fernbedienbaren Gerätes überträgt,
**dadurch gekennzeichnet,**
- daß der Fernbedienungsempfänger (15b) eine Lichtquelle (19) zur Erzeugung eines polarisierbaren Lichtes (7b) einer bestimmten Wellenlänge oder mit einer bestimmten Kennung enthält,
- daß der Fernbedienungsgeber (3b) einen Drucktaster (4) zum Einschalten des Sendebetriebes und mehrere unterschiedlich polarisierte Reflexionselemente (36, 37) enthält, deren räumliches Empfangs- und Rückstrahlfeld (38) durch Ebenen begrenzt ist, in denen die Zeigerrichtung (9) des Fernbedienungsgebers verläuft,
- und daß den Empfangselementen (14) des Fernbedienungsempfängers (15b) der Anordnung der polarisierten Reflexionselemente (36, 37) des Fernbedienungsgebers entsprechend polarisierte Polarisationsfilter (39) vorgeschaltet sind.

## Claims

1. Remote-controllable electrical appliance
- having a remote-control receiver and a manually operated remote-control transmitter which is wirelessly detached from the remote-control receiver and which has at least one transmitting element (52), between which receiver and transmitter transmitting elements radiate remote-control signals to receiving elements in order to characterize the angular deviation (alpha) of the pointer direction (9) of the remote-control transmitter (3), which is in operation, from a marker direction (13) which links the remote-control transmitter and a visual marker element (12) on the remote-control receiver (15),
- and having a direction detector (22) which, to set certain operating modes of the remote-controllable appliance, transmits to a command selector (24) control signals (23) which correspond to the angular deviation of the remote-control transmitter,
characterized
- in that the remote-control receiver (15c) contains a carrier-wave generator (59), which generates a carrier wave (7) having a certain identification signal, and a transmitting element (19) for radiating said carrier wave,
- in that there are disposed in the remote-control transmitter (3c):
-- a push-button switch (4) for switching on a transmitting mode of the remote-control transmitter (3c),
-- a plurality of receiving elements (50) for receiving the carrier wave (7), whose spatial reception field is bounded by planes in which the pointer direction (9) of the remote-control transmitter extends,
-- the direction detector (22), which is tuned to the identification signal of the carrier wave, and
-- a second carrier-wave generator (51), which is connected to the transmitting element (52),
- and in that the direction detector (22) generates control signals (23) which are modulated onto the carrier wave (45) which is generated in the second carrier-wave generator (51) as remote-control signals.

2. Remote-controllable electrical appliance according to Claim 1, characterized in that the viewing screen (49) of the remote-control receiver (15c) is at the same time transmitting element for radiating the carrier wave (7) and marker element, and in that the carrier-wave generator (59) which generates a carrier wave (7) with a certain identification signal is the line generator of the remote-control receiver (15c).

3. Remote-controllable electrical appliance
- having a remote-control receiver and a manually operated remote-control transmitter which is wirelessly separated from the remote-control receiver and has at least one transmitting element (42), between which receiver and transmitter transmitting elements radiate remote-control signals to receiving elements in order to characterize the angular deviation (alpha) of the pointer direction (9) of the remote-control transmitter (3), which is in operation, from a marker direction (13) which links the remote-control transmitter and a visual marker element (12) on the remote-control receiver (15)
- and having a direction detector (22) which, in order to set certain operating modes of the remote-controllable appliance, transmits to a command selector (24) control signals (23) which correspond to the angular deviation of the remote-control transmitter,
characterized
- in that the remote-control receiver (15b) contains a light source (19) for generating a polarizable light (7b) of a certain wavelength or having a certain identification signal,
- in that the remote-control transmitter (3b) has a push-button switch (4) for switching on the transmitting mode and a plurality of differently polarized reflection elements (36, 37) whose spatial reception field and re-radiation field (38) is bounded by planes in which the pointer direction (9) of the remote-control transmitter extends,
- and in that suitably polarized polarization filters (39) are situated upstream of the receiving elements (14) of the remote-control receiver (15b) of the arrangement of polarized reflection elements (36, 37) in the remote-control transmitter.

## Revendications

1. Appareil électrique pouvant être commandé à distance
- comportant un récepteur de télécommande et un émetteur de télécommande actionné manuellement, sans fil, éloigné du récepteur de télécommande et comportant au moins un élément émetteur (52), entre lesquels des éléments émetteurs envoient des signaux de télécommande à des éléments récepteurs pour caractériser la déviation angulaire (alpha) de la direction de pointage (9) de l'émetteur de télécommande (3) en fonctionnement, par rapport à une direction de repérage (13) qui relie l'émetteur de télécommande et un élément de repérage (12) visuel sur le récepteur de télécommande (15),
- et comportant un détecteur de direction (22) qui transmet à un sélecteur d'instructions (24) des signaux de commande (23) qui correspondent à la déviation angulaire de l'émetteur de télécommande, pour le réglage d'états de fonctionnement définis de l'appareil pouvant être commandé à distance,
**caractérisé** par le fait
- que le récepteur de télécommande (15c) comprend un générateur d'onde porteuse (59) qui produit une onde porteuse (7) possédant une caractéristique définie, et un élément émetteur (19) pour l'émission de cette onde porteuse,
- que sont disposés dans l'émetteur de télécommande (3c) :
-- un bouton-poussoir (4) destiné à déclencher le fonctionnement de l'émetteur de télécommande (3c)
-- plusieurs éléments récepteurs (50) pour la réception de l'onde porteuse (7) dont le champ de réception dans l'espace est limité par des plans dans lesquels passe la direction de pointage (9) de l'émetteur de télécommande
-- le détecteur de direction (22) qui est réglé sur la caractéristique de l'onde porteuse, et
-- un deuxième générateur d'onde porteuse (51) qui est relié à l'élément émetteur (52)
- et que le détecteur de direction (22) produit des signaux de commande (23) qui sont modulés en tant que signaux de télécommande sur l'onde porteuse (45) produite par le deuxième générateur d'onde porteuse (51).

2. Appareil électrique pouvant être commandé à distance selon la revendication 1, **caractérisé** par le fait que l'écran (49) du récepteur de télécommande (15c) est simultanément un élément émetteur pour l'émission de l'onde porteuse (7) et un élément de repérage et que le générateur d'onde porteuse (59) qui produit une onde porteuse (7) avec une caractéristique définie, est le générateur de lignes du récepteur de télécommande (15c).

3. Appareil électrique pouvant être commandé à distance
- comportant un récepteur de télécommande et un émetteur de télécommande actionné manuellement, sans fil, éloigné du récepteur de télécommande et comportant au moins un élément émetteur (42), entre lesquels des éléments émetteurs envoient des signaux de télécommande à des éléments récepteurs pour caractériser la déviation angulaire (alpha) de la direction de pointage (9) de l'émetteur de télécommande (3) en fonctionnement, par rapport à une direction de repérage (13) qui relie l'émetteur de télécommande et un élément de repérage (12) visuel sur le récepteur de télécommande (15),
- et comportant un détecteur de direction (22) qui transmet à un sélecteur d'instructions (24) des signaux de commande (23) qui correspondent à la déviation angulaire de l'émetteur de télécommande, pour le réglage d'états de fonctionnement définis de l'appareil pouvant être commandé à distance,
**caractérisé** par le fait
- que le récepteur de télécommande (15b) comporte une source lumineuse (19) pour la production d'une lumière (7b) polarisable possédant une longueur d'onde définie ou une caractéristique définie,
- que l'émetteur de télécommande (3b) comprend un bouton-poussoir (4) pour déclencher l'émission et plusieurs éléments de réflexion (36, 37) polarisés différemment dont le champ de réception et de réflexion (38) dans l'espace est limité par des plans dans lesquels passe la direction de pointage (9) de l'émetteur de télécommande
- et que sont montés en amont des éléments récepteurs (14) du récepteur de télécommande (15b), des filtres de polarisation (39) polarisés conformément à l'agencement des éléments de réflexion (36, 37) polarisés, de l'émetteur de télécommande.
